# EUROPEAN PATENT APPLICATION

(11) **EP 4 227 691 A1**
(43) Date of publication of application: **16.08.2023**
(21) Application number: 22156157.4
(22) Date of filing: 10.02.2022
(51) Int. Cl.: G01R 29/08

(54) **METHOD OF CLASSIFYING A RADIO FREQUENCY SIGNAL**

(71) Applicant: Rohde & Schwarz GmbH & Co. KG, 81671 München (DE)
(72) Inventor: Kuehne, Jens, 81671 München (DE)
(74) Representative: Prinz & Partner mbB

(57) **Abstract**

A method of classifying a radio frequency (RF) signal is described. The method comprises the following steps:
- receiving an RF signal and/or recorded data associated with the RF signal, wherein the RF signal comprises a characteristic signal pattern, wherein the characteristic signal pattern comprises a time-variant frequency;
- determining a frequency spectrum over time, wherein the frequency spectrum is associated with the RF signal;
- detecting the characteristic signal pattern based on the determined frequency spectrum and based on a priori knowledge about at least one potential emitter of the RF signal that uses a dedicated characteristic signal pattern; and
- classifying the RF signal based on the detected characteristic signal pattern.

Further, a system (10) for classifying a radio frequency (RF) signal is described.

## Description

The invention generally relates to a method of classifying a radio frequency signal. The invention further relates to a system for classifying a radio frequency signal.

Correctly identifying an emitter type of a particular radio frequency signal is important for a plurality of different applications, especially for regulation authorities and for security agencies, for instance at airports.

According to a well-known method in the state of the art, time-invariant parameters of the particular radio frequency signal are analyzed in order to identify the emitter type. For example, these time-invariant parameters comprise an RF frequency, a bandwidth, a modulation type, or modulation parameters of the particular radio frequency signal.

However, if the frequency band associated with the received signals is crowded, the known methods are prone to errors, particularly to false-positive errors, as signals may be falsely attributed to signal emitters due to their similar technical (time-invariant) parameters.

Thus, the object of the present invention is to provide of method of classifying a radio frequency signal with a reduced error probability.

According to the invention, the object is achieved by a method of classifying a radio frequency (RF) signal. The method comprises the following steps:
- receiving an RF signal and/or recorded data associated with the RF signal, wherein the RF signal comprises a characteristic signal pattern, wherein the characteristic signal pattern comprises a time-variant frequency;
- determining a frequency spectrum over time, wherein the frequency spectrum is associated with the RF signal;
- detecting the characteristic signal pattern based on the determined frequency spectrum and based on a priori knowledge about at least one potential emitter of the RF signal that uses a dedicated characteristic signal pattern; and
- classifying the RF signal based on the detected characteristic signal pattern.

Therein and in the following, the term "classify" is understood to denote determining the characteristic signal pattern of the RF signal and/or identifying the at least one potential emitter of the RF signal.

It is to be understood that the term "emitter" encompasses both a pure emitter, i.e. an electronic device that is configured to only emit RF signals, and a transceiver, i.e. an electronic device that is configured to receive and also transmit RF signals.

"Identifying the at least one potential emitter" may relate to determining the type of electronic device generating the RF signal, the specific model of the electronic device generating the RF signal, or even the serial number of the electronic device generating the RF signal.

The term "characteristic signal pattern" is understood to denote a characteristic pattern that the RF signal exhibits in time domain and in frequency domain, wherein the characteristic signal pattern comprises a time-variant frequency.

The characteristic signal pattern may be associated with a sequence of signal bursts, wherein each signal burst may have a certain duration, a certain amplitude (i.e. a certain energy), and a certain frequency.

Particularly, the signal bursts may have different durations, different amplitudes, and/or different frequencies.

For example, the RF signal may be a frequency hopping signal, such that consecutive portions of the RF signal, i.e. consecutive signal bursts, have different frequencies.

Accordingly, the characteristic signal pattern may comprise a frequency hopping pattern, particularly a fast frequency hopping (FFH) pattern.

Moreover, the "frequency spectrum over time" is understood to (also) comprise information on the time evolution of the frequency spectrum of the RF signal.

Within the present disclosure, the terms "frequency spectrum" and "frequency spectrum over time" are used as synonyms.

The frequency spectrum is determined based on the received RF signal and/or based on the recorded data that is associated with the RF signal. In other words, the frequency spectrum may be determined directly based on the received RF signal. Alternatively or additionally, a recording of the RF signal, which may have been recorded by another entity, may be used in order to determine the frequency spectrum. Hence, the recorded data may be accessed for further processing.

In general, the determined frequency spectrum does not only comprise information on the RF signal of interest, but also information on a multitude of other signals that are in the same frequency band as the RF signal and that are received together with the RF signal, for example perturbations or other signals from other signal sources such as WiFi senders.

The method according to the present invention is based on the idea to use a priori knowledge about the at least one potential emitter of the RF signal in order to classify the RF signal. More precisely, a priori knowledge about the dedicated characteristic signal pattern over time and frequency used by the at least one potential emitter is used in order to classify the RF signal.

The a priori knowledge is applied to the determined frequency spectrum over time, such that the determined frequency spectrum can purposefully be searched for the characteristic signal pattern.

In other words, the determined frequency spectrum does not have to be blindly searched for the characteristic signal pattern in order to classify the RF signal. Instead, the a priori knowledge about at least one potential emitter of the RF signal is used to specifically search the determined frequency spectrum for the characteristic signal pattern, particularly for the dedicated characteristic signal pattern. Thus, the RF signal can be classified in a reliable and fast manner.

The dedicated signal pattern may be uniquely associated with a particular emitter or with a particular class of emitters, particularly with the type of electronic device generating the RF signal, the specific model of the electronic device generating the RF signal, or even the serial number of the electronic device generating the RF signal. Thus, the RF signal can reliably be classified with a low error probability.

The a priori knowledge may be saved in a database. Thus, the a priori knowledge may correspond to data saved in the database.

The a priori knowledge may be generated and saved in the database manually by a human expert and/or automatically by downloading the corresponding information from a server.

According to an aspect of the present invention, a spectrogram is determined based on the determined frequency spectrum, wherein the characteristic signal pattern is detected based on the determined spectrogram. The spectrogram corresponds to an image of the frequency spectrum of the RF signal over time. Accordingly, image detection techniques may be applied to the spectrogram in order to detect the characteristic signal pattern in the spectrogram.

Particularly, the a priori information may comprise at least one reference image corresponding to the dedicated characteristic signal pattern. Thus, image detection techniques may be applied to the spectrogram, wherein an image similar to the at least one reference image is detected in the spectrogram in order to detect the characteristic signal pattern.

According to a further aspect of the present invention, the a priori knowledge is associated with the frequency spectrum over time. Thus, the a priori knowledge is associated with the dedicated characteristic signal pattern used by the at least one potential emitter and the frequency spectrum over time. The a priori knowledge may comprise information on which specific portions of the frequency spectrum over time, particularly of the spectrogram, may comprise the characteristic signal pattern. Thus, the frequency spectrum, particularly the specific portions of the frequency spectrum, can be specifically searched for the characteristic signal pattern, such that the RF signal can be classified in a reliable and fast manner.

In an embodiment of the present invention, an energy pattern over frequency and time of the RF signal is detected based on the frequency spectrum in order to detect the characteristic signal pattern. In other words, the frequency spectrum may be searched for the energy pattern of the RF signal in order to detect the characteristic signal pattern.

Particularly, the energy pattern may be the characteristic signal pattern.

In a further embodiment of the present invention, the energy pattern is detected based on the a priori knowledge. The energy pattern of the RF signal can reliably be detected based on the frequency spectrum in spite of strong perturbations and/or other high-amplitude signals being present, as the frequency spectrum can be specifically searched for the energy associated with the RF signal due to the a priori knowledge. Thus, the RF signal can be classified with low error probability even in the presence of strong perturbations.

According to another aspect of the present invention, at least one further characteristic parameter of the RF signal is determined, wherein the RF signal is classified based on the at least one further characteristic parameter, particularly wherein the detected characteristic signal pattern and/or the at least one further characteristic parameter are/is weighted with a weighting function in order to classify the RF signal. In general, the at least one further characteristic parameter is a parameter describing certain properties of the RF signal. Accordingly, the at least one further characteristic parameter may be associated with the characteristic signal pattern. Thus, further properties of the RF signal are taken into account for classifying the RF signal, such that the error probability is reduced even further.

In other words, the RF signal may be classified based on the detected characteristic signal pattern and based on the at least one further characteristic parameter, such that a hybrid classification of the RF signal is provided.

Therein, the detected characteristic signal pattern and the at least one further characteristic parameter may be weighted differently in order to classify the RF signal.

In general, the weighting function may be dependent on frequency and/or time, or may be constant.

Particularly, the detected characteristic signal pattern and different characteristic parameters may be weighted with different weighting functions, wherein the different weighting functions each may be dependent on frequency and/or time, or may be constant.

For example, one or several characteristic parameters that are uniquely associated with the potential signal emitter may be weighted higher than one or several other characteristic parameters that are common to a plurality of different possible signal emitters.

The at least one further characteristic parameter may be determined based on the detected characteristic signal pattern. In other words, only portions of the frequency spectrum that are actually associated with the RF signal may be considered for determining the at least one further characteristic parameter. Thus, the probability of errors is further reduced.

Particularly, the at least one further characteristic parameter comprises a frequency hopping pattern, a modulation type, a burst length, a bandwidth, and/or a symbol rate. In other words, the RF signal may be classified based on the frequency hopping pattern, the modulation type, the burst length, the bandwidth, and/or the symbol rate of the RF signal.

The characteristic signal pattern may be detected by means of a machine-learning technique. Alternatively or additionally, the RF signal may be classified by means of a machine-learning technique. In general, any suitable machine-learning technique may be used in order to detect the characteristic signal pattern and/or in order to classify the RF signal, for example random forests, deep learning, reinforcement learning, dimensionality reduction, regression analysis, etc.

For example, machine-learning based image detection techniques may be used in order to detect the characteristic signal pattern.

Particularly, the a priori information may comprise at least one reference image corresponding to the dedicated characteristic signal pattern. Thus, machine-learning based image detection techniques may be applied to the spectrogram, wherein an image similar to the at least one reference image is detected in the spectrogram in order to detect the characteristic signal pattern.

According to an aspect of the present invention, a Fourier transform of the RF signal is calculated in order to determine the frequency spectrum, particularly wherein a fast Fourier transform and/or a short-time Fourier transform is calculated. These operations can be performed in real-time, such that a fast processing of the RF signal is guaranteed.

In an embodiment of the present invention, the a priori knowledge is associated with a frequency hopping pattern. In other words, the a priori knowledge may be associated with a hop pattern grid employed by the potential signal emitter. Thus, the frequency spectrum can be specifically searched for a characteristic signal pattern matching the frequency hopping pattern.

According to the invention, the problem further is solved by a system for classifying a radio frequency (RF) signal. The system comprises an input module and an analysis module. The input module is configured to receive an RF signal and/or recorded data associated with the RF signal. The RF signal comprises a characteristic signal pattern, wherein the characteristic signal pattern comprises a time-variant frequency. The analysis module is configured to determine a frequency spectrum over time, wherein the frequency spectrum is associated with the RF signal. The analysis module is further configured to detect the characteristic signal pattern based on the determined frequency spectrum and based on a priori knowledge about at least one potential emitter of the RF signal that uses a dedicated characteristic signal pattern. The analysis module is further configured to classify the RF signal based on the detected characteristic signal pattern.

Particularly, the system is configured to perform the method of classifying a radio frequency signal described above.

Regarding the further advantages and properties of the system, reference is made to the explanations given above with respect to the method, which also hold for the system and vice versa.

The analysis module may comprise a spectral processing module, wherein the spectral processing module is configured to determine the frequency spectrum over time associated with the RF signal.

The analysis module may comprise a classifier module, wherein the classifier module is configured to classify the RF signal based on the detected characteristic signal pattern.

In an embodiment of the present invention, the system is integrated into an electronic device, in particular a handheld device that is portable. For example, the electronic device may be a measurement device, such as a spectrum analyzer, a signal analyzer or an oscilloscope, particularly a digital oscilloscope.

However, the system may also be integrated into a stationary electronic device.

According to an aspect of the present invention, the system further comprises a power supply module, in particular wherein the power supply module comprises an integrated power source. For example, the power supply module may comprise a battery, a power generator, particularly a gasoline-operated or diesel-operated power generator, a photovoltaics module, and/or a connector for connecting the system with the power grid.

For example, the integrated power source may comprise a battery and/or a photovoltaics module. This is particularly advantageous if the system is integrated into a handheld device that is portable, as the system can be operated autonomously, i.e. independent of an external power source.

According to another aspect of the present invention, the input module comprises at least one RF antenna, wherein the at least one RF antenna is configured to receive the RF signal.

The at least one RF antenna may be established as a directional antenna, such that only signals from a specific direction are received.

Particularly, the at least one RF antenna may be established as an external RF antenna that is connected to the remainder of the input module and/or to the analysis module.

For example, the input module may comprise an RF antenna array with several RF antennas.

The input module may further comprise an amplifier module connected to the at least one RF antenna, wherein the amplifier module is configured to amplify the RF signal.

Further, the input module may comprise a mixer module that is configured to down-convert the RF signal to an intermediate frequency (IF) that is suitable for further analysis by the analysis module.

Particularly, the mixer module is configured to generate an IQ signal associated with the RF signal by adequately mixing the RF signal with two phase-shifted local oscillator signals. Thus, amplitude and phase information about the RF signal is provided by means of the IQ signal.

According to a further aspect of the present invention, the analysis module comprises a machine-learning module, wherein the machine-learning module is trained to detect the characteristic signal pattern based on the determined frequency spectrum and based on the a priori knowledge, and/or wherein the machine-learning module is trained to classify the RF signal based on the detected characteristic signal pattern.

For example, the machine-learning module comprises an artificial neural network that is trained to detect the characteristic signal pattern based on the determined frequency spectrum and based on the a priori knowledge, and/or to classify the RF signal based on the detected characteristic signal pattern.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a system according to the present invention; and
- Figure 2 shows a flow chart of a method of classifying a radio frequency signal according to the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

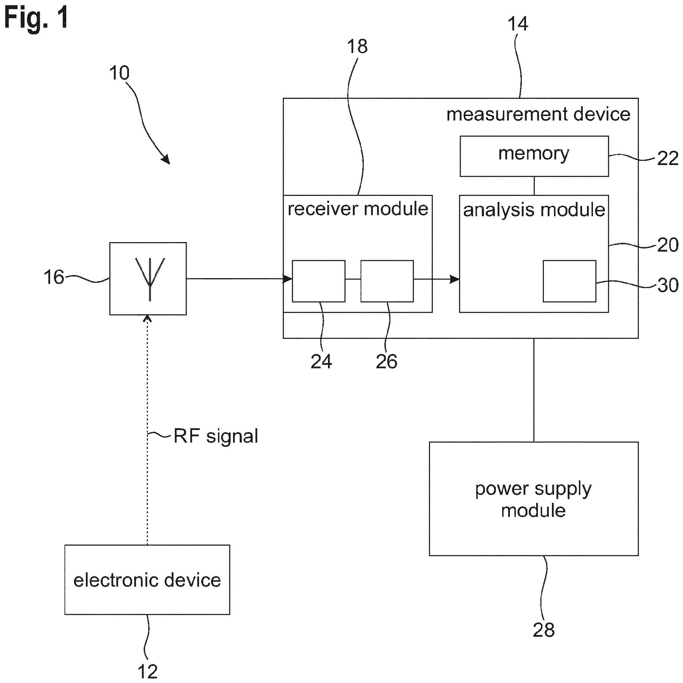

Figure 1 schematically shows a system 10 for classifying a radio frequency (RF) signal, wherein the RF signal is transmitted by an electronic device 12.

Therein and in the following, the term "classify" is understood to denote determining a characteristic signal pattern comprised in the RF signal and/or identifying at least one potential emitter of the RF signal.

"Identifying the at least one potential emitter" may relate to determining the type of the electronic device 12 generating the RF signal, the specific model of the electronic device 12 generating the RF signal, or even the serial number of the electronic device 12 generating the RF signal.

For example, the electronic device 12 may be a remote control that is configured to remote-control another electronic device, such as a drone.

Alternatively, the electronic device 12 may be established as a RF radio communication device.

The system 10 comprises a measurement device 14 that is connected with at least one RF antenna 16 in a signal transmitting manner.

Therein and in the following, the term "connected in a signal transmitting manner" is understood to denote a cable-based or wireless connection that is configured to transmit signals between the respective devices or components.

The at least one RF antenna 16 may be an external RF antenna that is established separately from the measurement device 14. However, it is to be understood that the RF antenna 16 may also be integrated into the measurement device 14.

The at least one RF antenna 16 may be established as directional antenna that is configured to receive RF signals from a specific main receiving direction. The main receiving direction of the at least one RF antenna 16 may be adjustable, for example by rotating the at least one RF antenna 16 or by adapting receiving parameters of the at least one RF antenna 16.

For example, several (directional) RF antennas 16 may be provided that form an RF antenna array.

The measurement device 14 comprises an input module 18 being connected with the RF antenna 16, an analysis module 20 that is connected with the input module 18, and a memory 22.

Therein and in the following, the term "module" is understood to describe suitable hardware, suitable software, or a combination of hardware and software that is configured to have a certain functionality.

The hardware may, inter alia, comprise a central processing unit (CPU), a graphics processing unit (GPU), a field programmable gate array (FPGA), an application-specific integrated circuit (ASIC), a general purpose processor (GPP), a digital signal processor (DSP), or other types of electronic circuitry.

Alternatively to being integrated into the measurement device 14, the input module 18 may be established as an external RF receiver.

The input module 18 comprises an amplifier module 24 and/or a mixer module 26, the functionality of which will be described in more detail below.

The system 10 further comprises a power supply module 28. In general, the power supply module 28 is configured to supply power to the measurement device 14.

For example, the power supply module 28 may comprise a battery, a power generator, particularly a gasoline-operated or diesel-operated power generator, a photovoltaics module, and/or connector for connecting the system with the power grid.

It is noted that while the power supply module 28 is illustrated to be established separately from the measurement device 14 in Figure 1, the power supply module 28 may also be at least partially integrated into the measurement device 14, particularly completely.

For example, the measurement device 14 may comprise an integrated battery and/or an integrated photovoltaics module, which is particularly advantageous if the measurement device 14 is established as a portable electronic device, such that the measurement device 14 can be operated autonomously, i.e. independent of an external power source.

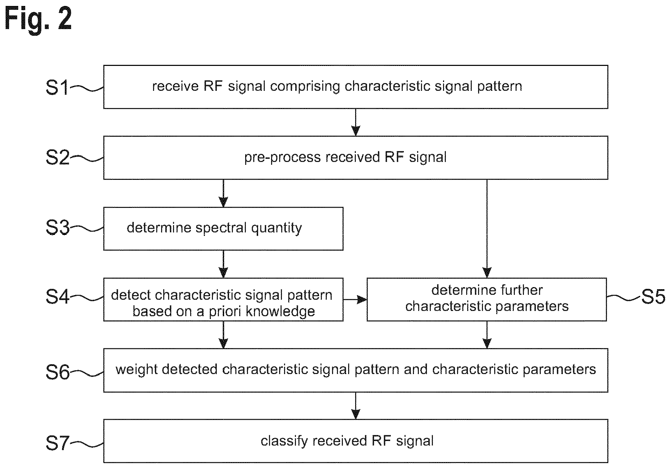

The system 10 is configured to perform a method of classifying an RF signal, which is described in the following with reference to Figure 2.

The RF signal transmitted by the electronic device 12 is received by means of the at least one RF antenna 16 (step S1).

The received RF signal is forwarded to the input module 18.

Alternatively, recorded data associated with the RF signal transmitted by the electronic device 12 may be received by means of the input module 18.

The recorded data may have been recorded by another entity or by the measurement device 14 itself. In the latter case, the recorded data 14 may have been saved in the memory 22 and may be loaded into the input module 18 or the analysis module 20 for further processing, as described hereinafter.

The RF signal is pre-processed by means of the input module 18, thereby obtaining a pre-processed RF signal (step S2).

The RF signal may be amplified by means of the amplifier module 24.

Moreover, the RF signal may be down-converted to an intermediate frequency (IF) by means of the mixer module 26, wherein the IF is suitable for further analysis by the analysis module 20.

Particularly, the mixer module 26 generates an IQ signal associated with the RF signal by adequately mixing the RF signal with two phase-shifted local oscillator signals.

Thus, the pre-processed RF signal may comprise the IQ signal associated with the RF signal. Accordingly, information about the phase and the amplitude of the RF signal may be provided to the analysis module 20.

A frequency spectrum over time associated with the RF signal is determined by means of the analysis module 20 based on the pre-processed RF signal (step S3).

For example, a Fourier transform of the pre-processed RF signal is calculated in order to determine the frequency spectrum, particularly wherein a fast Fourier transform and/or a short-time Fourier transform is calculated.

In general, the frequency spectrum over time comprises information on the time evolution of the frequency spectrum of the RF signal.

Particularly, a spectrogram may be determined based in the determined frequency spectrum.

However, the frequency spectrum not only comprises information on the RF signal received from the electronic device 12, but also information on any other signals that in the same frequency band as the RF signal and that are received together with the RF signal, for example perturbations or RF signals from other signal sources such as WiFi senders.

A characteristic signal pattern of the RF signal is detected based on the determined frequency spectrum, particularly based on the determined spectrogram, and based on a priori knowledge about a dedicated characteristic signal pattern used by a potential emitter of the RF signal (step S4).

The a priori knowledge is saved in a database stored in the memory 22, which can be accessed by the analysis module 20.

Thus, the a priori knowledge corresponds to data saved in the memory 22.

The a priori knowledge may be generated and saved in the database manually by a human expert and/or automatically by downloading the corresponding information from a server.

The term "characteristic signal pattern" is understood to denote a characteristic pattern that the RF signal exhibits in time domain and in frequency domain with respect to the amplitude (i.e. the energy) of the RF signal and with respect to a time-variant frequency of the RF signal.

The characteristic signal pattern may be associated with a sequence of signal bursts, wherein each signal burst may have a certain duration, a certain amplitude (i.e. a certain energy), and a certain frequency.

Particularly, the signal bursts may have different durations, different amplitudes, and/or different frequencies.

For example, the RF signal may be a frequency hopping signal, such that consecutive portions of the RF signal, i.e. consecutive signal bursts, have different frequencies.

Accordingly, the characteristic signal pattern may comprise a frequency hopping pattern, particularly a fast frequency hopping pattern.

Particularly, the characteristic signal pattern may be an energy pattern.

In general, the determined frequency spectrum over time is purposefully searched based on the a priori knowledge in order to detect the characteristic signal pattern.

Without restriction of generality, a specific example is described in the following, wherein a spectrogram is determined based on the determined frequency spectrum of the RF signal.

Image detection techniques may be applied to the spectrogram in order to detect the characteristic signal pattern in the spectrogram.

Particularly, the a priori information may comprise at least one reference image corresponding to the dedicated characteristic signal pattern. Thus, image detection techniques may be applied to the spectrogram, wherein an image similar to the at least one reference image is detected in the spectrogram in order to detect the characteristic signal pattern.

Particularly, the analysis module 20 comprises a machine-learning module 30 that applies machine-learning based image detection techniques to the spectrogram in order to detect the characteristic signal pattern in the spectrogram.

However, it is to be understood that any other suitable machine-learning technique may be used in order to detect the characteristic signal pattern.

Optionally, at least one further characteristic parameter of the RF signal is determined by means of the analysis module 20 based on the pre-processed RF signal, particularly based on the detected characteristic signal pattern (step S5).

In general, the at least one further characteristic parameter is a parameter describing certain properties of the RF signal.

Particularly, the at least one further characteristic parameter comprises a frequency hopping pattern, a modulation type, a burst length, a bandwidth, and/or a symbol rate.

The detected characteristic signal pattern and the at least one further characteristic parameter are weighted with a weighting function, respectively (step S6).

In general, the weighting function may be dependent on frequency and/or time, or may be constant.

Therein, the detected characteristic signal pattern and the at least one further characteristic parameter may be weighted differently, i.e. with different weighting functions.

Moreover, different characteristic parameters may be weighted with different weighting functions.

For example, one or several characteristic parameters that are uniquely associated with the potential signal emitter may be weighted higher than one or several other characteristic parameters that may be common to a plurality of different possible signal emitters.

The RF signal is classified based on the detected characteristic signal pattern and based on the at least one further determined characteristic signal parameter (step S7).

Therein, the detected characteristic signal pattern and the at least one further determined characteristic signal parameter are weighted as described above with reference to step S6.

The detected characteristic signal pattern and/or the at least one further determined characteristic signal parameter may be compared with a database of reference characteristic signal parameters and/or reference characteristic parameters in order to classify the RF signal.

The database of reference characteristic signal parameters and/or reference characteristic parameters may be saved in the memory 22 of the measurement device 14.

Alternatively or additionally, the RF signal may be classified via a suitable machine-learning technique by means of the machine-learning module 30, i.e. the machine-learning module may be trained to classify the RF signal based on the detected characteristic signal pattern, and optionally based on the at least one further characteristic signal parameter.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A method of classifying a radio frequency (RF) signal, wherein the method comprises the following steps:
- receiving an RF signal and/or recorded data associated with the RF signal, wherein the RF signal comprises a characteristic signal pattern, wherein the characteristic signal pattern comprises a time-variant frequency;
- determining a frequency spectrum over time, wherein the frequency spectrum is associated with the RF signal;
- detecting the characteristic signal pattern based on the determined frequency spectrum and based on a priori knowledge about at least one potential emitter of the RF signal that uses a dedicated characteristic signal pattern; and
- classifying the RF signal based on the detected characteristic signal pattern.

2. The method of claim 1, wherein a spectrogram is determined based on the determined frequency spectrum, and wherein the characteristic signal pattern is detected based on the determined spectrogram.

3. The method according to any one of the preceding claims, wherein the a priori knowledge is associated with the frequency spectrum over time.

4. The method according to any one of the preceding claims, wherein an energy pattern over frequency and time of the RF signal is detected based on the frequency spectrum in order to detect the characteristic signal pattern.

5. The method according to claims 3 and 4, wherein the energy pattern is detected based on the a priori knowledge.

6. The method according to any one of the preceding claims, wherein at least one further characteristic parameter of the RF signal is determined, and wherein the RF signal is classified based on the at least one further characteristic parameter, particularly wherein the detected characteristic signal pattern and/or the at least one further characteristic parameter are/is weighted with a weighting function in order to classify the RF signal.

7. The method according to claim 6, wherein the at least one further characteristic parameter comprises a frequency hopping pattern, a modulation type, a burst length, a bandwidth, and/or a symbol rate.

8. The method according to any one of the preceding claims, wherein the characteristic signal pattern is detected by means of a machine-learning technique and/or wherein the RF signal is classified by means of a machine-learning technique.

9. The method according to any one of the preceding claims, wherein a Fourier transform of the RF signal is calculated in order to determine the frequency spectrum, particularly wherein a fast Fourier transform and/or a short-time Fourier transform is calculated.

10. The method according to any one of the preceding claims, wherein the a priori knowledge is associated with a frequency hopping pattern.

11. A system for classifying a radio frequency (RF) signal, wherein the system (10) comprises an input module (18) and an analysis module (20),
wherein the input module (18) is configured to receive an RF signal and/or recorded data associated with the RF signal, wherein the RF signal comprises a characteristic signal pattern, wherein the characteristic signal pattern comprises a time-variant frequency,
wherein the analysis module (20) is configured to determine a frequency spectrum over time, wherein the frequency spectrum is associated with the RF signal,
wherein the analysis module (20) is further configured to detect the characteristic signal pattern based on the determined frequency spectrum and based on a priori knowledge about at least one potential emitter of the RF signal that uses a dedicated characteristic signal pattern, and
wherein the analysis module (20) is further configured to classify the RF signal based on the detected characteristic signal pattern.

12. The system of claim 11, wherein the system (10) is integrated into an electronic device, in particular a handheld device that is portable.

13. The system of claim 11 or 12, wherein the system (10) further comprises a power supply module (28), in particular wherein the power supply module (28) comprises an integrated power source.

14. The system according to any one of the claims 11 to 13, wherein the input module (18) comprises at least one RF antenna (16), wherein the at least one RF antenna (16) is configured to receive the RF signal.

15. The system according to any one of the claims 11 to 14, wherein the analysis module (20) comprises a machine-learning module (30), wherein the machine-learning module (30) is trained to detect the characteristic signal pattern based on the determined frequency spectrum and based on the a priori knowledge, and/or wherein the machine-learning module (30) is trained to classify the RF signal based on the detected characteristic signal pattern.
